(19) **Europäisches Patentamt**
**European Patent Office**
**Office européen des brevets**

(11) **EP 2 693 645 A2**

(12) **EUROPEAN PATENT APPLICATION**

(43) Date of publication:
**05.02.2014 Bulletin 2014/06**

(51) Int Cl.:
*H04B 1/04* (2006.01)   *H04J 11/00* (2006.01)
*H04L 27/26* (2006.01)   *H04L 25/03* (2006.01)

(21) Application number: **13178579.2**

(22) Date of filing: **30.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.07.2012 GB 201213612**

(71) Applicant: **TRL Technology Limited Gloucestershire GL20 8ND (GB)**

(72) Inventor: **Jones, Keith John Weymouth, Dorset DT4 9NA (GB)**

(74) Representative: **Emerson, Peter James et al Page Hargrave Whitefriars Lewins Mead Bristol BS1 2NT (GB)**

(54) **Low-complexity sheme for enhancing multi-carrier communications**

(57)   The locations and/or strengths of inter-modulation products in a modulated multi-carrier signal transmission, are predicted by:
a) producing a polynomial arithmetic expression associated with the generation of 3rd order and/or 5th order inter-modulation products arising from the combining of all of the multi-carrier signal subsets of the transmission associated with those inter-modulation products, and
b) embedding the polynomial arithmetic expression between a single FFT/IFFT pair, such that the locations and strengths of all 3rd order and/or all 5th order inter-modulation products are predicted.

Additionally, the frequency channel location of one of those carrier signals that are responsible for the generation of IMD in the transmission is determined by:
c) partitioning the plurality of carrier signal channels into a plurality of non-overlapping subsets,
d) determining the reduction in the strength of inter-modulation products resulting from the removal of each subset from the transmission, and
e) comparing the determined strengths,
whereby the subset whose removal results in the largest determined reduction in strength of inter-modulation products in the channel of interest is determined to be primarily responsible for the generation of inter-modulation distortion in the signal.

Fig. 3

EP 2 693 645 A2

**Description**

The present invention relates to, a communications method which comprises a method for predicting the locations and / or strengths of inter-modulation products (IMPs) in a modulated multi-carrier signal transmission and a method for determining, for a modulated multi-carrier signal transmission comprising a plurality of non-overlapping frequency channels, the frequency channel location of one of those carrier signals that are responsible for the generation of inter-modulation distortion (IMD) in the transmission, and apparatus for carrying out such a method.

In the field of wireless communications, it is known that a power amplifier (PA), or indeed any non-linear component, may produce distortions in the communications when the communications equipment used operates over an adjacent band of frequencies. It is often the case for example that the communications equipment itself may comprise such a PA.

The distortion arises as a result of the non-linear nature of the PA when used for transmitting multi-carrier signals, and may appear at a number of frequencies with predictable locations distributed across the frequency spectrum including that frequency, or set of frequencies, over which one wishes to communicate.

In more detail, the problem arises with the use of PAs for modern wireless communications due to the non-linear nature of their transfer characteristic. More specifically, when a single PA is used for the transmission of modulated multi-carrier signals, the PA non-linearity may result in the generation of undesirable IMD, as expressed in the form of IMPs, which may occur at various frequencies distributed across the spectrum. This can be a serious problem when strong (particularly those due to 3rd order and 5th order non-linear effects) IMPs occur at frequencies at which one wishes to carry out communications.

With modern wireless communication systems, e.g. whereby multi-carrier signals are used so as to achieve increased flexibility and spectral efficiency in an environment where user demand may be variable, the associated data is typically spread over different information streams which in turn modulate different carrier signals, these modulated signals being subsequently transmitted with highly-efficient signalling techniques such as orthogonal frequency division multiplexing (OFDM) or multi-carrier spread spectrum (MC-SS). With the adoption of such techniques, however, when large numbers of modulated carriers are assigned to the same PA, there will inevitably be problems arising from the corruption of adjacent or coincident channels that need to be kept clear from the resulting IMD.

To address this problem, it would be of great benefit, given the known frequency locations of the carrier signals, to be able firstly to predict the locations and strengths of all the dominant IMPs arising from the use of the PA and, subsequently, to be able to adjust in some way the locations of one or more (according to their contributions to the distortion) of the carrier signals so that those IMPs preventing or seriously degrading communications are sufficiently reduced in strength to enable reliable communications to take place. The conventional approach, referred to here as the 'direct method', to the problem of predicting IMP locations, however, is combinatorial in nature, so that a real-time solution to the IMP location prediction problem for realistic numbers of channels and carrier signals is not considered cost effective. As a consequence, the subsequent task of clearing channels of interest of IMD for the purposes of reliable communications has not been seriously addressed due to the associated level of complexity.

As prior art in this field may be mentioned the following references:

[1] S.G. Akl, "The Design and Analysis of Parallel Algorithms", Prentice-Hall, Upper Saddle River, NJ, 1989.
[2] G. Baruffa & G. Reali, "A Fast Counting Method for Generic Order Inter-Modulation Products", Proc. IEEE Global Telecomms. Conf. (GLOBECOM '02), Taipei, Taiwan, Nov. 2002, pp. 2036-2040.
[3] N.M. Blachman, "Detectors, Bandpass Non-Linearities and their Optimization: Inversion of the Chebyshev Transform", IEEE Trans on information Theory, Vol. 17, July 1971, pp. 398-404.
[4] R.N. Bracewell, "The Hartley Transform", Oxford University Press, New York, 1986.
[5] E. Chu & A. George, "Inside the FFT Black Box", CRC Press, Boca Raton, Fl. 2000.
[6] D.C. Green, "Radio Communication", Longman, 2nd edition, 2000.
[7] D. Harel, "Algorithmics: The Spirit of Computing", Addison-Wesley, 2"° Edition, 1997.
[8] KJ. Jones, "The Regularized Fast Hartley Transform", Springer, 2010.
[9] A.V. Oppenheim & R.W. Schafer, "Discrete-Time Signal Processing", Prentice-Hall, Englewood Cliffs, N.J., 1989.
[10] T.S. Rappaport, "Wireless Communications: Principles and Practice", Prentice-Hall PTR, Upper Saddle River, N.J., 1999.

It is an aim of the present invention to overcome these problems, and thus provide a methodology for reducing distortion, as well as a device which enables the quality of communications to be improved at a given frequency, or set of frequencies, when in the  presence of distortion generated by a PA or other non-linear component within the transmit chain.

This aim is achieved by defining a suite of processing algorithms that will:

a) perform the task of predicting the locations and strengths of all 3rd order and/or 5th order IMPs arising from the combining of all possible multi-carrier signal subsets taken from the available set of carrier signals;
b) perform the task of adjusting in some way the locations of one or more (according to their contributions) of the carrier signals so that those IMPs preventing or seriously degrading communications are sufficiently reduced in strength to enable reliable communications to take place; and
c) be computationally efficient enough to enable the implementation of both a) and b) to be carried out in real time.

These algorithms may then be performed by a device.

N.B. It should be noted that the term 'strength' is used here and throughout this document to refer to the number of IMP contributions that occur simultaneously within a given channel, rather than to the power associated with the channel content.

As a result, the inventive device enables the prediction of the frequency locations and strengths of the distortion and, when the distortion occurs at one or more of those frequencies over which one wishes to communicate, the subsequent clearance of that distortion from that frequency, or set of frequencies, regardless of the levels of distortion present. The speed at which the device is able to clear the distortion from the communication frequency, or set of frequencies, is sufficient to enable reliable communications to be maintained without having to interrupt the operation of the electronic equipment.

Prior art - the "direct method"

Preliminary Definitions for Algorithmic Complexity:

It is first useful to provide a few basic definitions relating to the complexity of a given algorithm or process and how this is measured:

a) An algorithm is said to have an arithmetic complexity of order 'N', denoted O(N), if the number of arithmetic operations involved is less than K x N for some constant 'K' and for sufficiently large 'N';
b) A polynomial function of 'N' is defined as one which is bounded from above by $N^K$ for some constant 'K' - meaning that it is no greater in value than $N^K$ for all values of 'N' from some point onwards;
c) A polynomial-time algorithm is defined as one whose order of magnitude time-complexity is bounded from above by a polynomial function of 'N' where 'N' is the size of its inputs; and
d) A superpolynomial-time algorithm is simply defined as one which is not a polynomial-time algorithm.

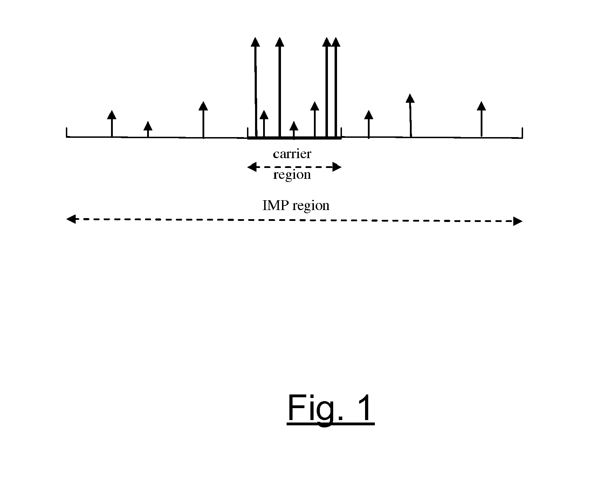

A computationally-efficient technique has already been developed and described in the technical literature (see reference [2] above), based upon the use of the fast Fourier transform (FFT), which is able to reduce the complexity of the original combinatorial IMP location/strength prediction problem, for simple combinations of IMD, to approximately O(MxlogM). The parameter 'M' represents the total number of frequency channels that encompass both the carrier signal region as well as those regions either side of it within which the IMPs might also occur. It should be noted that, as a result of real-world expectations, consideration is restricted to the first zone of the pass-band non-linearity which corresponds to that region containing the first harmonics of the non-linear PA outputs. This is illustrated in Fig. 1 which shows a set of carrier signals of equal amplitude appearing in the central part of the spectrum together with varying amplitude IMPs, as generated by the carriers, distributed across the carrier region and the surrounding first zone of pass-band non-linearity. The algorithm has been shown to work for a number of specific 3rd order and 5th order examples using simple multi-carrier signal subsets. This involved embedding the polynomial arithmetic associated with the generation of the IMPs arising from the combining of a single multi-carrier signal subset between one forward FFT and one inverse FFT (IFFT) - a detailed derivation of the IMP location/strength prediction algorithm being provided below.

Detailed derivation of IMP location/strength predication algorithm

The following derivation is as discussed in the prior art of reference [2].

When 'N' carrier signals residing at frequencies $f_1$, $f_2$, ..., $f_N$, are passed through a non-linear PA, an IMP will be produced at frequency:

$$f_{IMP} = \sum_{n=1}^{N} k_n . f_n$$

(1)

where

$$O = \sum_{n=1}^{N} |k_n|$$

(2)

is referred to as the *order* of the IMP. By selecting the set of values of $k_n$ - referred to as the *channel weights* - to be such that

$$\sum_{n=1}^{N} k_n = 1$$

(3)

it can also be ensured that the corresponding IMP falls within the first zone of the pass-band non-linearity of the PA. The task then is to determine all the frequency locations occupied by the resulting IMPs together with the number of such contributions - yielding an 'approximation' to the power associated with the channel content referred to as the IMP 'strength' - that occur at each frequency. The conventional 'direct method' accomplishes this in a combinatorial fashion by means of an exhaustive enumeration of all possible carrier signal combinations, so that as the number of possible carrier signal locations increases and the number of carrier signals being combined increases, the associated complexity becomes increasingly unmanageable. The problem may be simplified through the assumptions:

a) all carrier signal frequencies are multiples of the channel bandwidth so that the centre frequencies of the IMPs are also, as a result, multiples of the channel bandwidth; and b) that all carrier signals have the same amplitude and modulation type so that the IMPs, as a result, possess the same power. Given the expected variability of the carrier signal amplitudes in a real-world scenario, therefore, the 'strength' of the IMD within a specific channel can only be considered to be an approximation to the power associated with the channel content, although it is nevertheless an important indicator of the relative levels of IMD actually present in the channel (or channels) of interest.

If a real-time solution is sought then an alternative approach needs to be found.

To begin the task, if 'N' now corresponds to the maximum number of channels within which the carrier signals might occur, then the *indicator polynomial* is that polynomial of order N-1

$$g(z) = \sum_{n=0}^{N-1} b_n \cdot z^n$$

(4)

for which each coefficient, $b_n$, has a value of either '0' or '1', with a '0' for the $n^{th}$ coefficient indicating the absence of a carrier signal in the $n^{th}$ channel and a '1' indicating the presence of a carrier signal in the $n^{th}$ channel. Then, for example, $3^{rd}$ order IMPs may be represented by means of a polynomial p(z) with coefficients, $\{c_n\}$, that represent the number of IMPs that fall within the $n^{th}$ channel

$$p(z) = \sum_{n=N_{min}}^{N_{max}} c_n \cdot z^n = \sum_{n_1=0}^{N-1} \sum_{n_2=0}^{N-1} \sum_{n_3=0}^{N-1} b_{n_1} \cdot b_{n_2} \cdot b_{n_3} \cdot z^{n_1+n_2-n_3}$$

(5)

for $n_1 \neq n_2$, $n_2 \neq n_3$ and $n_3 \neq n_1$ where '$N_{min}$' and '$N_{max}$' represent, respectively, the lower and upper frequency ranges of interest. Clearly, each coefficient, $c_n$, increments its value whenever the locations of the carrier signals $n_1$, $n_2$ and $n_3$ are such that $n_1 + n_2 - n_3 = n$.

To see how this expression might be used to help in predicting the locations of 3rd order and 5th order IMPs, the function

$$C_n^b\left(\overline{k}_n\right) \equiv C_n^b(k_1, k_2, \ldots, k_n)$$

(6)

is introduced that represents the distribution of IMPs generated by a linear combination of 'n' carrier signals with indices given by the channel weights ($k_1, k_2, \ldots, k_n$). Each such n-tuple may be used to represent a linear combination of carrier signals at different frequencies - bearing in mind that some combinations may actually correspond to the same IMP. The IMP locations of interest range from channel numbers

$$N_{min} \approx -\frac{1}{2}(N \times order)$$

(7)

up to

$$N_{max} \approx N + \frac{1}{2}(N \times order)$$

(8)

where the parameter 'order' corresponds to the maximum order of IMPs being considered. To illustrate the function's use, the original set of carrier signal locations may be represented as

$$C_1^b\left(\overline{k}_1\right) \equiv C_1^b(k_1) = \sum_{n_1=0}^{N-1} b_{n_1} \cdot z^{k_1 \cdot n_1} \equiv \sum_{n_1=0}^{N-1} b_{n_1} \cdot z^{n_1}$$

(9)

for when $k_1 = 1$, or the 3rd-order IMP for $\overline{k}_3 = (+1, +1, -1)$ as

$$C_3^b\left(\overline{k}_3\right) = \sum_{n_1=0}^{N-1}\sum_{n_2=0}^{N-1}\sum_{n_3=0}^{N-1} b_{n_1} \cdot b_{n_2} \cdot b_{n_3} \cdot z^{n_1+n_2-n_3}$$

(10)

for $n_1 \neq n_2$, $n_2 \neq n_3$ and $n_3 \neq n_1$.

Given that all the 3rd order and 5th order IMPs of interest may be catered for by the use of one or more of the functions $C_2^b\left(\overline{k}_2\right)$, $C_3^b\left(\overline{k}_3\right)$, $C_4^b\left(\overline{k}_4\right)$ and $C_5^b\left(\overline{k}_5\right)$, the next task is to find some mechanism for expressing these functions, for all valid arguments, $\overline{k}_n$, in terms of the original set of carrier signal locations, as expressed via the function

$C_1^b(k_1)$ of Equation 9. To proceed, a little algebraic manipulation combined with a little insight produces:

$$C_2^b(\overline{k}_2) = C_1^b(k_1).\,C_1^b(k_2) - C_1^b(k_1 + k_2)$$

$$(11)$$

which means that the combining of all 2-carrier signal subsets may be expressed in terms of the original carrier signal locations, followed (using increased algebraic manipulation) by

$$C_3^b(\overline{k}_3) = C_1^b(k_1).\,C_1^b(k_2).\,C_1^b(k_3) - C_1^b(k_1 + k_2).\,C_1^b(k_3) - \cdots$$
$$C_1^b(k_2 + k_3).\,C_1^b(k_1) - C_1^b(k_1 + k_3).\,C_1^b(k_2) + 2C_1^b(k_1 + k_2 + k_3)$$

$$(12)$$

which means that the combining of all 3-carrier signal subsets may also be expressed in terms of the original carrier signal locations, followed (using even more algebraic manipulation) by

$$C_4^b(\overline{k}_4) = C_1^b(k_1).\,C_1^b(k_2).\,C_1^b(k_3).\,C_1^b(k_4) + 2C_1^b(k_1).\,C_1^b(k_2 + k_3 + k_4) + \cdots$$
$$2C_1^b(k_2).\,C_1^b(k_1 + k_3 + k_4) + 2C_1^b(k_3).\,C_1^b(k_1 + k_2 + k_4) + \cdots$$
$$2C_1^b(k_4).\,C_1^b(k_1 + k_2 + k_3) + C_1^b(k_1 + k_2).\,C_1^b(k_3 + k_4) + \cdots$$
$$C_1^b(k_1 + k_3).\,C_1^b(k_2 + k_4) + C_1^b(k_1 + k_4).\,C_1^b(k_2 + k_3) - \cdots$$
$$C_1^b(k_1 + k_2).\,C_1^b(k_3).\,C_1^b(k_4) - C_1^b(k_1 + k_3).\,C_1^b(k_2).\,C_1^b(k_4) - \cdots$$
$$C_1^b(k_1 + k_4).\,C_1^b(k_2).\,C_1^b(k_3) - C_1^b(k_2 + k_3).\,C_1^b(k_1).\,C_1^b(k_4) - \cdots$$
$$C_1^b(k_2 + k_4).\,C_1^b(k_1).\,C_1^b(k_3) - C_1^b(k_3 + k_4).\,C_1^b(k_1).\,C_1^b(k_2) - \cdots$$

$$6C_1^b(k_1 + k_2 + k_3 + k_4)$$

$$(13)$$

which means that the combining of all 4-carrier signal subsets may also be expressed in terms of the original carrier signal locations. Thus, each of these expressions may subsequently be used in the simplification of the expression for the 5-carrier case, as follows:

$$C_5^b(\bar{k}_5) = C_1^b(k_1).C_1^b(k_2).C_1^b(k_3).C_1^b(k_4).C_1^b(k_5) - \cdots$$

$$C_4^b(k_1 + k_2, k_3, k_4, k_5) - C_4^b(k_1 + k_3, k_2, k_4, k_5) - \cdots$$

$$C_4^b(k_1 + k_4, k_2, k_3, k_5) - C_4^b(k_1 + k_5, k_2, k_3, k_4) - \cdots$$

$$C_4^b(k_2 + k_3, k_1, k_4, k_5) - C_4^b(k_2 + k_4, k_1, k_3, k_5) - \cdots$$

$$C_4^b(k_2 + k_5, k_1, k_3, k_4) - C_4^b(k_3 + k_4, k_1, k_2, k_5) - \cdots$$

$$C_4^b(k_3 + k_5, k_1, k_2, k_4) - C_4^b(k_4 + k_5, k_1, k_2, k_3) - \cdots$$

$$C_3^b(k_1 + k_2 + k_3, k_4, k_5) - C_3^b(k_1 + k_2 + k_4, k_3, k_5) - \cdots$$

$$C_3^b(k_1 + k_2 + k_5, k_3, k_4) - C_3^b(k_1 + k_3 + k_4, k_2, k_5) - \cdots$$

$$C_3^b(k_1 + k_3 + k_5, k_2, k_4) - C_3^b(k_1 + k_4 + k_5, k_2, k_3) - \cdots$$

$$C_3^b(k_2 + k_3 + k_4, k_1, k_5) - C_3^b(k_2 + k_3 + k_5, k_1, k_4) - \cdots$$

$$C_3^b(k_2 + k_4 + k_5, k_1, k_3) - C_3^b(k_3 + k_4 + k_5, k_1, k_2) - \cdots$$

$$C_3^b(k_1 + k_2, k_3 + k_4, k_5) - C_3^b(k_1 + k_2, k_3 + k_5, k_4) - \cdots$$

$$C_3^b(k_1 + k_2, k_4 + k_5, k_3) - C_3^b(k_1 + k_3, k_2 + k_4, k_5) - \cdots$$

$$C_3^b(k_1 + k_3, k_2 + k_5, k_4) - C_3^b(k_1 + k_3, k_4 + k_5, k_2) - \cdots$$

$$C_3^b(k_1 + k_4, k_2 + k_3, k_5) - C_3^b(k_1 + k_4, k_2 + k_5, k_3) - \cdots$$

$$C_3^b(k_1 + k_4, k_3 + k_5, k_2) - C_3^b(k_1 + k_5, k_2 + k_3, k_4) - \cdots$$

$$C_3^b(k_1 + k_5, k_2 + k_4, k_3) - C_3^b(k_1 + k_5, k_3 + k_4, k_2) - \cdots$$

$$C_3^b(k_2 + k_3, k_4 + k_5, k_1) - C_3^b(k_2 + k_4, k_3 + k_5, k_1) - \cdots$$

$$C_3^b(k_2 + k_5, k_3 + k_4, k_1) - C_2^b(k_1, k_2 + k_3 + k_4 + k_5) - \cdots$$

$$C_2^b(k_2, k_1 + k_3 + k_4 + k_5) - C_2^b(k_3, k_1 + k_2 + k_4 + k_5) - \cdots$$

$$C_2^b(k_4, k_1 + k_2 + k_3 + k_5) - C_2^b(k_5, k_1 + k_2 + k_3 + k_4) - \cdots$$

$$C_2^b(k_1 + k_2, k_3 + k_4 + k_5) - C_2^b(k_1 + k_3, k_2 + k_4 + k_5) - \cdots$$

$$C_2^b(k_1 + k_4, k_2 + k_3 + k_5) - C_2^b(k_1 + k_5, k_2 + k_3 + k_4) - \cdots$$

$$C_2^b(k_2 + k_3, k_1 + k_4 + k_5) - C_2^b(k_2 + k_4, k_1 + k_3 + k_5) - \cdots$$

$$C_2^b(k_2 + k_5, k_1 + k_3 + k_4) - C_2^b(k_3 + k_4, k_1 + k_2 + k_5) - \cdots$$

$$C_2^b(k_3 + k_5, k_1 + k_2 + k_4) - C_2^b(k_4 + k_5, k_1 + k_2 + k_3) - \cdots$$

$$C_1^b(k_1 + k_2 + k_3 + k_4 + k_5).$$

$$(14)$$

It should be noted that the full expansion using just the original carrier signal locations is not shown here, for practical reasons of space, given that the expression involves the combining of 5! = 120 terms. Note that for each of the expressions given by Equations 11 to 14, most of the contributions arise from the subtraction from the sum of free-running indices all those terms where two or more of the sequence of channel weights, $\{k_n\}$, are linearly combined, this being done to account for the situation where a carrier signal appears more than once in the linear combination which yields the IMP centre frequency.

Thus, the problem of predicting the locations and strengths of all 3$^{rd}$ order and/or 5$^{th}$ order IMPs of interest may be expressed purely in terms of polynomial arithmetic involving the indicator polynomial. The task now is to see how the arithmetic complexity associated with the task of determining the coefficients of the polynomial representing the IMP strength distribution may be simplified sufficiently to facilitate a real-time implementation.

Supposing firstly that the number of channels representing the frequency region from '$N_{min}$' to '$N_{max}$' is given by 'M', where M > N, then by setting 'z' in the polynomial expression of Equation 4 to be the $M^{th}$ complex root of unity, i.e.

$$z = e^{-i2\pi/M}$$

$$(15)$$

so that the polynomials are evaluated over 'M' distinct and equi-distant points on the unit circle of the complex plane, we are able to express each such polynomial as the discrete Fourier transform (DFT) - denoted '$G_n$' hereafter - of the corresponding set of polynomial coefficients, such that

$$G_n \equiv g(z_n) = \sum_{m=0}^{M-1} b_m . e^{-i2\pi mn/M} \quad \text{for } n = 0,1, ..., \text{M-1}$$

$$(16)$$

where the coefficient set, $\{b_m\}$, has been zero-extended from 'N' terms to 'M' terms. As a result, the set of polynomial coefficients, $\{c_{\bar{k}_2}^b(p)\}$, corresponding to the 2-carrier expression, $C_2^b(\bar{k}_2)$, for example, may be written as

$$c_{\bar{k}_2}^b(p) = S_{M+N_{min}} \left( IDFT\left(G_{k_1 n} . G_{k_2 n} - G_{(k_1+k_2)n}\right)\right),$$

$$(17)$$

from Equation 11, where the operator $S_{M+N_{min}}$ circularly shifts its vector operand by $M+N_{min}$ locations. The purpose of the circular shifting operation is simply to ensure that the 'N' coefficients corresponding to the carrier signal region lies in the centre of the resulting coefficient set, with ½(M-N) coefficients appearing to either side.

Note that from the periodicity of the exponential function of Equation 15, which possesses period 'M', each output of the sequence $\{G_{kn}\}$ is equal to one of the outputs of the sequence $\{G_n\}$ and can be obtained by simply rotating $\{G_n\}$ by the appropriate amount. More precisely, the $(kn)^{th}$ output of $\{G_{kn}\}$ is equal to the $m^{th}$ output of $\{G_n\}$, where

$$m = n \times k \text{ modulo M.}$$

$$(18)$$

As a result, $\{G_{kn}\}$ is referred to as a "cyclic re-sampling" (CRS) of $\{G_n\}$ and a device that performs this function is referred to hereafter as a "cyclic re-sampler".

Similar expressions to that of Equation 17 may be found for Equations 12, 13 and 14, so that by exploiting the linearity of the DFT, the coefficients corresponding to the generation of both 3rd order and 5th order IMPs, as given by the summation $C_2^b(\bar{k}_2) + C_3^b(\bar{k}_3) + C_4^b(\bar{k}_4) + C_5^b(\bar{k}_5)$ - noting that some terms will exist for both 3rd order and 5th order cases - may be found via the expression

$$c_{\bar{k}_2,\bar{k}_3,\bar{k}_4,\bar{k}_5}^b(p) = S_{M+N_{min}} \left( IDFT\left(f_2(G_n, \bar{k}_2) + f_3(G_n, \bar{k}_3) + f_4(G_n, \bar{k}_4) + f_5(G_n, \bar{k}_5)\right)\right)$$

$$(19)$$

where $f_m(G_n, \overline{k}_m)$, for m = 2, 3, 4 and 5, is the DFT-based representation for all valid m-carrier products, so that only one DFT/IDFT pair need actually be computed for finding the locations and strengths of all 3rd order and/or 5th order IMPs, this being efficiently achieved with the implementation of a suitably defined FFT routine.

Finally, it should be noted that the validity of the DFT-based approach adopted here is consistent with the fact that the problem of linearly convolving two sequences of numbers is equivalent to that of deriving the coefficients of a polynomial resulting from the product of two smaller polynomials. This can be efficiently solved by applying the FFT to a zero-padded version of the coefficient set of each small polynomial, multiplying element-wise the two resulting spectra, before applying the IFFT to the resulting spectral product. This is similar to what is being carried out here, except that the cyclic nature of the required convolution - due to the fact that IMPs occurring at frequencies outside of the region of interest will be expected to alias back into the region of interest - means that there is no need for zero-padding of the two coefficient sets, as we are actually performing the polynomial multiplication modulo ($z^M$-1). As a result of this formulation, the arithmetic complexity of the predictor is of the same order as that for the M-point FFT or IFFT, namely O(MxlogM), i.e. such that the number of operations is less than C x M x logM, for some constant 'C' and for sufficiently large 'M'.

Present invention

In accordance with a first aspect of the present invention there is provided a communications method comprising, as a first step, a method for predicting the locations and/or strengths of inter-modulation products in a modulated multi-carrier signal transmission, comprising the steps of:

a) producing a polynomial arithmetic expression associated with the generation of 3rd order and/or 5th order inter-modulation products arising from the combining of all of the multi-carrier signal subsets of the transmission associated with those inter-modulation products, and

b) embedding the polynomial arithmetic expression between a single FFT/IFFT pair, such that the locations and strengths of all 3rd order and/or all 5th order inter-modulation products are predicted;

and, as a second step, a method for determining, for a modulated multi-carrier signal transmission comprising a plurality of non-overlapping frequency channels, the frequency channel location of one of those carrier signals that are responsible for the generation of inter-modulation distortion in the transmission, comprising the steps of:

c) partitioning the plurality of carrier signal channels into a plurality of non-overlapping subsets,

d) determining the reduction in the strength of inter-modulation products resulting from the removal of each subset from the transmission, and

e) comparing the determined strengths,

whereby the subset whose removal results in the largest determined reduction in strength of inter-modulation products in the channel of interest is determined to be primarily responsible for the generation of inter-modulation distortion in the signal;

and whereby the locations and strengths of all 3rd order and/or all 5th order inter-modulation products predicted in step b) are used in step d);

the method further comprising the step of removing or relocating the carrier signal at the location determined in step e) to reduce the residual level of inter-modulation distortion in the transmission frequency channel of interest.

The inter-modulation products may comprise 3rd order inter-modulation products, and the multi-carrier signal subsets associated with those inter-modulation products comprise 2-carrier and 3-carrier signal subsets.

The inter-modulation products may alternatively or additionally comprise 5th order inter-modulation products, and the multi-carrier signal subsets associated with those inter-modulation products comprise 2-carrier, 3-carrier, 4-carrier and 5-carrier signal subsets.

The transmission takes place over a range of non-overlapping frequency channels, and step a) may comprise setting up a binary polynomial coefficient set in dependence of the presence of a carrier signal within a frequency channel, for each such frequency channel. The coefficient set may be transformed from the data domain to the Fourier domain. In this case, the transformation may be carried out using an FFT routine.

The transformed set may be cyclically re-sampled to produce expressions for individual carrier signal subsets. The expressions may then be combined to form a single expression, for example by applying an element-wise vector product (EWVP) to the expressions.

The single expression may be transformed from the Fourier domain to the data domain to provide a coefficient set for the polynomial representation of the IMP distribution. In this case, the transformation may be carried out using an IFFT routine.

The execution of each FFT/IFFT routine may comprise the use of a real-data transform.

Steps c) and d) may be repeated for the subset whose removal results in the largest determined reduction in strength of inter-modulation products, to increase the accuracy of location.

Step d) may comprise determining the reductions in strengths of all 3rd order and/or all 5th order inter-modulation products in said transmission.

The method may comprise repeatedly removing or relocating additional carrier signals at the determined location until the residual level of inter-modulation distortion is reduced to below a threshold amount, to enable reliable communications. The method may terminate as soon as a sufficient number of carrier signals have been removed, or relocated, when the residual level of inter-modulation distortion is reduced to below the threshold.

In accordance with a second aspect of the present invention there is provided apparatus for performing a method according to the first aspect of the invention.

The description will now be described with reference to the accompanying drawings, of which:

Fig. 1 schematically shows the partitioning of channels into carrier frequency region and first zone of pass-band non-linearity, as used both by conventional methods and the present invention;
Fig. 2 shows a flowchart outline of a single-path processing scheme for real-time prediction of IMP locations and strengths in accordance with the present invention;
Fig. 3 shows a flowchart outline of a dual-path processing scheme for real-time prediction of IMP locations and strengths in accordance with the present invention;
Fig. 4 shows a flowchart outline of a processing scheme for real-time clearance of a channel of interest in accordance with the present invention;
Fig. 5 shows a flowchart of a coarse-grained computational pipeline for the inventive method;
Fig. 6 shows a schematic block diagram of individual components of a device in accordance with the present invention, and interactions therebetween; and
Fig. 7 shows a schematic block diagram of a device in accordance with the present invention, including its interaction with the outside world.

As a consequence of the threat to multi-carrier communications performance from IMPs, a two-stage processing technique has been developed in accordance with the present invention which achieves the desired objective of reliable communications, in a computationally-efficient manner, such that real-time performance might be realistically achieved. The first stage of the inventive technique concerns the prediction of the IMP locations and strengths, for realistic combinations of IMD, whilst a second stage concerns the subsequent removal or relocation of one or more (according to their contributions) of those carrier signals that are mainly responsible for generating the IMD at the user's communication frequencies.

Stage 1 - IMP location and/or strength determination

Accordingly, for the first stage, a generalized version of the IMP location/strength prediction algorithm referred to above is defined which extends the applicability of the work described above, being able to use the same minimum complexity algorithms to predict the locations and strengths of either:

a) all 3rd order IMPs arising from the combining of all possible 2-carrier and 3-carrier signal subsets taken from the available set of carrier signals; or
b) all 5th order IMPs arising from the combining of all possible 2-carrier, 3-carrier, 4-carrier and 5-carrier signal subsets taken from the available set of carrier signals; or
c) both of the above, either separately or combined.

This involves being able to embed the polynomial arithmetic associated with the generation of the IMPs arising from the combining of all - as opposed to some specific one - of the multi-carrier signal subsets between just one FFT/IFFT pair, instead of having to assign a separate FFT/IFFT pair to each specific IMD type.

From the detailed derivation provided above, where the set of channel weights for the case of an n-carrier signal subset is written as $\overline{k}_n = (k_1, k_2, ...., k_n)$, the IMP location/strength prediction problem decomposes into the following distinct tasks:-

1) to transform the indicator polynomial coefficient set from the data domain to the Fourier domain via the discrete Fourier transform (DFT) to yield a sequence of spectral samples $\{G_n\}$ - this achieved with a suitably defined FFT processor;
2) to produce cyclically re-sampled versions of the resulting spectrum so as to cater for those IMD types of interest, i.e. produce $\{G_{\hat{k}_2 n}\}$ where index $\hat{k}_2$ spans the number of combinations for each set of valid channel weights, $\overline{k}_2$, for the case of 2-carrier signal subsets; $\{G_{\hat{k}_3 n}\}$ where index $\hat{k}_3$ spans the number of combinations for each set of valid

channel weights, $\overline{k}_3$, for the case of 3-carrier signal subsets; $\{G_{\hat{k}4n}\}$ where index $\hat{k}_4$ spans the number of combinations for each set of valid channel weights, $\overline{k}_4$, for the case of 4-carrier signal subsets; and $\{G_{\hat{k}5n}\}$ where index $\hat{k}_5$ spans the number of combinations for each set of valid channel weights, $\overline{k}_5$, for the case of 5-carrier signal subsets - this being achieved with a suitably defined cyclic re-sampler;

3) to combine the resulting expressions to obtain a single expression catering for those IMD types of interest - this being achieved with a suitably defined EWVP operator combined with straightforward vector additions/subtractions; and

4) to transform the resulting expression back from the Fourier domain to the data domain via the inverse DFT (or IDFT) to obtain the coefficient set for the polynomial representation of the IMD distribution for those IMD types of interest - this being achieved with a suitably defined IFFT processor or even with the FFT processor already described for transformation to the Fourier domain (by conjugating both the input and the output).

It should be noted that the number of combinations, denoted $|\overline{k}_n|$, over which the index $\hat{k}_n$ ranges for each set of valid channel weights, $\overline{k}_n$, is given by the expression

$$|\overline{k}_n| = \sum_{m=1}^{n} C[m,n]$$

(20)

where C[m,n] is the Binomial Coefficient with value

$$C[m,n] = {n!}\big/{m!\,(n-m)!}$$

(21)

with 'n!' the factorial operation such that n! = 1 x 2 x ... x n and 0! = 1.

The assumptions made in solving the IMP location/strength prediction problem are, according to both the present invention and the prior art, that:- a) all carrier signal frequencies are multiples of the channel bandwidth so that the centre frequencies of the IMPs are also, as a result, multiples of the channel bandwidth; and b) that all carrier signals have the same amplitude and modulation type so that the IMPs, as a result, possess the same power. Given the expected variability of the carrier signal amplitudes in a real-world scenario, therefore, the 'strength' of the IMD within a specific channel can only be considered to be an approximation to the power associated with the channel content, although it is nevertheless an important indicator of the relative levels of IMD actually present in the channel (or channels) of interest.

Assuming the carrier signal region to be represented by 'N' channels and the total IMD region of interest (as defined by the first zone of the pass-band non-linearity) to be represented by 'M' channels, the arithmetic cost of predicting the locations and strengths of all the 3rd order IMPs can be expressed in terms of length-M FFT operations, length-M IFFT operations, length-½M CRS operations and length-½M EWVP operations - see above, as

$$A_3 = 1\ \text{FFT} + 1\ \text{IFFT} + 9\ \text{CRSs} + 5\ \text{EWVPs},$$

(22)

with an approximate memory requirement of

$$M_3 = N + 9 \times (M+2)$$

(23)

words, whilst that for predicting the locations and strengths of all the 5th order IMPs can be expressed as

$$A_5 = 1 \text{ FFT} + 1 \text{ IFFT} + 60 \text{ CRSs} + 92 \text{ EWVPs},$$

(24)

with an approximate memory requirement of

$$M_5 = N + 44 \times (M+2)$$

(25)

words, and that for predicting the locations and strengths of both as

$$A_{3+5} = 1 \text{ FFT} + 1 \text{ IFFT} + 69 \text{ CRSs} + 97 \text{ EWVPs}$$

(26)

with an approximate memory requirement of

$$M_{3+5} = N + 44 \times (M+2)$$

(27)

words. To obtain these complexity figures, the initial formulations of the algebraic expressions have been re-ordered so as to minimize the overall arithmetic complexity - particularly large savings are obtained via this re-ordering for the computationally intensive 4-carrier and 5-carrier combinings required for the 5th order component of the IMP location/ strength prediction algorithm.

The reduced-complexity expression for the combining of an arbitrary 5-carrier subset is not provided in the existing technical literature. Its derivation here, as with the 2-carrier, 3-carrier and 4-carrier combinings, has been produced entirely by means of 'hand, pencil and brain', rather than via the use of a commercially-available symbolic expression manipulation tool. This has enabled computational savings to be obtained by identifying and exploiting the fact that some computations are common to more than one multi-carrier subset, i.e. some computations for the 2-carrier case are also required for the 3-carrier case; some computations for the 3-carrier case are also required for the 4-carrier case; and some computations for the 4-carrier case are also required for the 5-carrier case. It should be noted, however, that verification of the correctness of the suite of processing algorithms described by the proposed invention has been carried out in software using the MatLab computing environment.

Each CRS operation involves the execution of ½M modulo reductions, whilst each EWVP operation involves the execution of ½M+1 complex multiplications. For the case of analyzing just the 3rd order IMPs, the length of the FFT/ IFFT routines needs to be set to approximately 3 times the number of useable carrier signal channels, i.e. $M \approx 3N$, whilst for the case of analyzing just the 5th order (and, therefore, for the combined 3rd order and 5th order) IMPs, it needs to be set to approximately 5 times the number of useable channels, i.e. $M \approx 5N$. It should be noted also that through the exploitation of conjugate (i.e. Hermitian) spectral symmetry, the arithmetic complexity and memory requirement for the EWVPs and their subsequent combining are each halved through simply restricting the length of the stored vectors to just one half the length of the FFT/IFFT routines (plus one to account for largest negative frequency for when the transform length is an even integer).

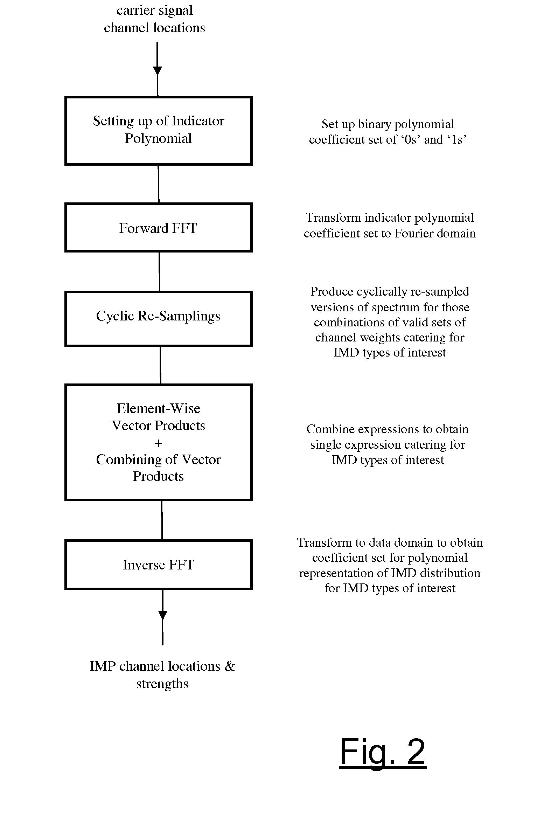

Fig. 2 shows a flowchart outline of a single-path processing scheme for real-time prediction of IMP locations and strengths for this first stage. This outlines the processing requirements for this initial IMP location/strength prediction stage of the proposed system, i.e. the first stage, where a 'single-path' scheme facilitates the prediction of IMP locations and strengths for 3rd order, 5th order or 'combined' 3rd order and 5th order cases.

It can be seen from Fig. 2 that the following steps are carried out using the carrier signal channel locations:

1. Setting up of "indicator" polynomial

A binary polynomial coefficient set of "0s" and "1s" is set up, hereafter referred to as the "indicator" polynomial coefficient set.

## 2. Forward FFT

The indicator polynomial coefficient set is transformed from the data domain to the Fourier domain.

## 3. Cyclic re-samplings

Cyclically re-sampled versions of the spectrum for those combinations of valid sets of channel weights catering for IMD types of interest are produced.

## 4. Element-wise vector products + combining of vector products

The expressions are combined to obtain a single expression catering for IMD types of interest.

## 5. Inverse FFT

The expression is transformed from the Fourier domain to the data domain to obtain a coefficient set for polynomial representation of IMD distribution for IMD types of interest. This coefficient set provides the IMP channel locations and strengths.
Compared to earlier work carried out on IMP location/strength prediction (described for example in reference [2]), generalizations are made here for the inventive system in that it is now possible to:-

a) handle, simultaneously and at low computational cost, multiple 3rd order and/or 5th order expressions by exploiting the linearity of the FFT; as well as
b) significantly reduce the arithmetic complexity of the EWVPs and their subsequent combining by exploiting the property of conjugate symmetry of the spectrum of the indicator polynomial and its cyclically re-sampled versions; and
c) exploit the real-valued nature of the FFT input data and the IFFT output data.

The linearity of the DFT/IDFT and hence of the FFT/IFFT, as represented by the operators 'F' for forward operation and 'F$^{-1}$' for inverse operation, simply states that

$$F(g_1 + g_2) = F(g_1)+F(g_2)$$

$$(28)$$

and

$$F^{-1}(G_1 + G_2) = F^{-1}(G_1) + F^{-1}(G_2)$$

$$(29)$$

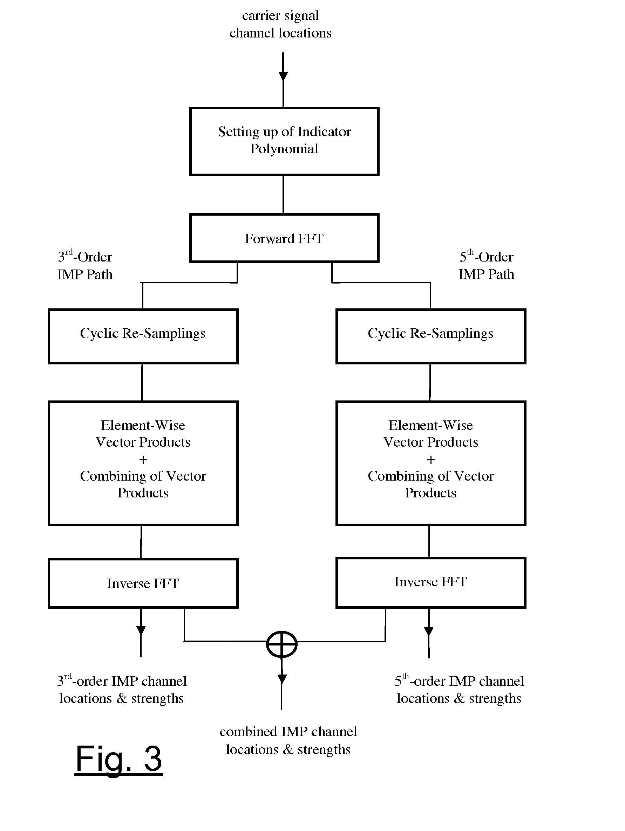

Its importance for the problem considered here is that it enables one to embed the combining of all possible multi-carrier signal subsets, for 3rd order and/or 5th order cases, between just one FFT/IFFT pair, instead of having to assign a separate FFT/IFFT pair to each specific IMD type.
It should be noted that the prediction of IMP locations and strengths could be carried out by adopting separate processing chains running in parallel, for the 3rd order and 5th order cases, with the total strength of each IMP being therefore split into separate 3rd order and 5th order components. This would certainly lead to a better understanding of the likely levels and sources of IMD, for any particular channel of interest, given the increased relative distortion levels to be expected with the 3rd order terms. It could only be achieved, however, at increased computational cost. This is illustrated in Fig. 3 where a 'dual-path' scheme facilitates the prediction of IMP locations and strengths for 'separate' 3rd order and 5th order cases. The processing chain following the execution of the initial FFT routine must be replicated for the task of predicting the IMP locations and strengths for each IMD type.

Stage 2 - channel clearance

Having thus determined the locations and strengths of the IMPs for all 3rd order and/or 5th order IMD, it only remains to locate one or more (according to their contributions) of those carrier signals that are mainly responsible for generating the IMD at the user's communication frequencies. This problem, however, like that of the IMP location/strength prediction problem already discussed, is essentially combinatorial in nature, since to find the "best" solution would effectively require the estimation of every possible solution before being able to identify the best one, so that the solution would thus require a superpolynomial-time algorithm. Therefore, in order to achieve a solution that is efficient enough to lend itself to a realizable implementation, it is necessary that a suitable optimization criterion be defined such that a quick route may be found to the finding of just *one possible solution* that may be said to be optimal in some fashion, i.e. one involving a polynomial-time algorithm that achieves the required level of IMD reduction in the channel or channels of interest.

The resulting computational efficiency of the first stage of the proposed system, the IMP location and strength predictor, enables it to be used as a key component of the second stage (described below), namely that of channel clearance, where it facilitates an efficient search through the carrier signal region in order to find the location(s) of one or more (according to their contributions) of those carrier signals that make a significant contribution to the IMD in the channel or channels of interest. The resulting two-stage processing system is able to maintain reliable communications for multi-carrier communication systems by reducing the amount of IMD within the communication channel or channels at a computational cost that is sufficiently low as to facilitate a real-time implementation.

Thus, for the second stage, a fixed-radix search algorithm is defined, based upon the "divide and conquer" principle, where the number of frequency channels, 'N', in which the carrier signals may occur, is expressible as

$$N = R^E$$

$$(30)$$

where 'R' is referred to as the search algorithm radix and 'E' as the associated exponent - in much the same way as a recursive fixed-radix FFT algorithm is defined (as is known in the art - see reference [5] above). The search algorithm decomposes into 'E' stages where, at each stage, the number of channels of interest, which is initially set to 'N', is reduced according to the adopted optimization criterion by a factor 'R', so that after all 'E' stages have been completed just a single channel is left. The optimization criterion needs to ensure that when the carrier signal occupying this remaining channel is removed the power content of the IMD occurring in the channel of interest will be significantly reduced or, possibly, even eliminated. The precise operation of this algorithm is described below.

To commence the channel clearance algorithm, the set of 'N' possible carrier signal channels is firstly partitioned into 'R' non-overlapping (and equal-sized) subsets of 'N/R' consecutive channels. The IMP location/strength prediction algorithm is then applied 'R' times, each time operating with a modified version of the indicator polynomial - which is a binary polynomial (i.e. one possessing binary coefficients) representing the channel activity - whereby a different set of 'N/R' consecutive polynomial coefficients is zeroized for each instance of the IMP location/strength prediction algorithm. The modified version of the indicator polynomial that leads to the smallest strength of IMD in the communication channel of interest is taken to indicate which subset of consecutive channels possesses the carrier signal or signals that have made the greatest contribution to the distortion. When two or more subsets each attain the smallest value, then for consistency, the subset chosen is always that lying closest to the channel we are attempting to clear - that lying farthest away could equally be chosen. For stage two, the number of 'N/R' consecutive channels that resulted in the smallest strength of IMD is partitioned into 'R' non-overlapping subsets each of 'N/R2' consecutive channels and the above process is repeated in order to refine the estimate of the location of that subset of channels that is most likely to have caused the distortion. This process is repeated for all 'E' stages, in a recursive fashion, which results in the location of a single carrier signal channel together with an estimate of the strength of the residual IMD in the channel of interest. The remaining carrier signal channel is thus one of a potentially large number of such channels that is likely to have contributed significantly to the occurrence of the IMD in the channel of interest.

If the residual IMD is less than or equal to a pre-determined, e.g. user-specified, threshold then the channel clearance algorithm may be terminated at this point, as the objective has already been achieved. If the residual IMD exceeds it, however, then the original indicator polynomial may be modified according to the above result (by setting to zero the 'bit' corresponding to the troublesome carrier signal) and the channel clearance algorithm repeated in order to further reduce the strength of the residual IMD present in the channel of interest. This may be repeated an arbitrary number of times, in an iterative fashion, according to an additional user-specified parameter set up at run time and relating the maximum number of iterations to be carried out in order to achieve adequate suppression of the residual IMD. As a result, the arithmetic complexity associated with the clearance of the channel equates to that required for E x R instances of the IMP location/strength prediction algorithm multiplied by the number of attempts made or needed to achieve adequate clearance.

It should be noted that the threshold level is specified as the required percentage reduction of the initial channel strength to be achieved after channel clearance has been performed. Thus, a figure of 90% for the threshold means that the strength of inter-modulation products within the channel of interest has to be reduced to below 10% of its initial value.

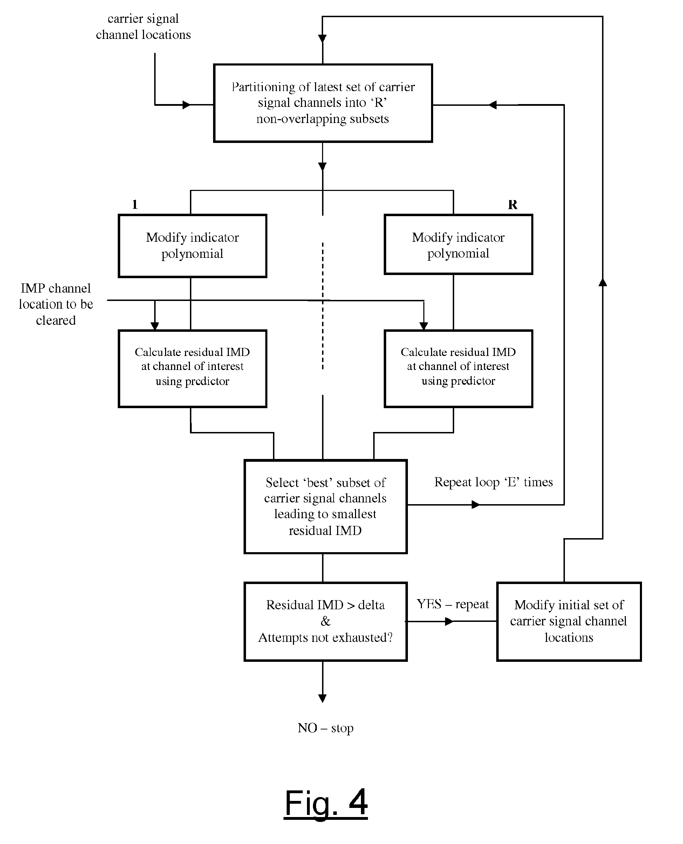

Thus, summarizing this second stage, the search algorithm has looked to identify, for a given radix, 'R', a sequence of embedded channel subsets, $\{S_n\}$, where n = 1, 2, ..., E and $S_{n+1} \subset S_n$, i.e. where subset $S_{n+1}$ is totally contained within subset $S_n$, such that the final single-channel subset, $S_E$, when removed, results in a significant reduction in IMD in the channel of interest. An outline of the processing requirements for this second stage is as given in Fig. 4. Given that the channel clearance algorithm involves the execution of E x R instances of the IMP location/strength prediction algorithm, each of which possesses an O(MxlogM) arithmetic complexity, then since E = O(logM), as implied by Equation 30 and the fact that M ≈ 5N when dealing with both 3rd order and 5th order IMPs, the associated arithmetic complexity equates to $O(M{\times}log^2M)$.

The channel clearance algorithm is designed for the maintenance of reliable communications at a single frequency. Clearly, this may be repeated in a straightforward fashion to facilitate the maintenance of reliable communications at multiple frequencies ensuring each time that the indicator polynomial has been appropriately updated by the previous result. The arithmetic complexity associated with the combined IMP location/ strength prediction and channel clearance tasks, for a single communication frequency, is equivalent to that required for

$$N_{total} = 1 + (E \times R \times \text{no. of attempts})$$

(31)

instances of the IMP location/strength prediction algorithm, where the user-defined parameter 'no. of attempts' corresponds to the number of attempts made or needed to achieve adequate IMD clearance from the channel of interest.

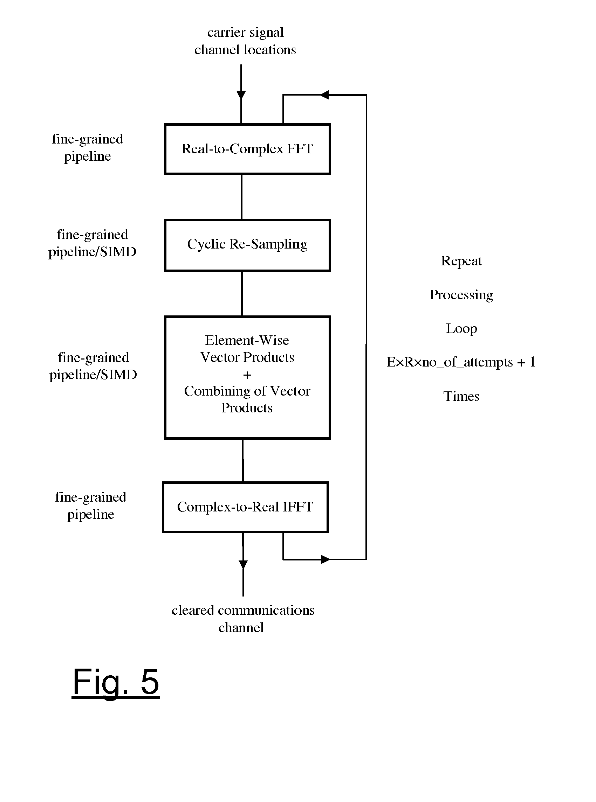

Fig. 5 schematically shows an outline of a possible partitioning scheme for parallelization of the proposed system. Given the fact that the sets of CRS operations, EWVP operations and the subsequent vector product combining operations may each be partitioned into multiple independent tasks, parallel processing techniques may be effectively exploited so as to maximize the computational throughput of the proposed system, and this is achieved via a combination of coarse-grained pipelining and fine-grained pipelining and single-instruction multiple-data (SIMD) multi-processing techniques. Advantage may also be taken of the fact that the forward FFT maps real-valued data to complex-valued data and the inverse FFT maps the complex-valued data of the conjugate symmetric spectrum to real-valued data, making desirable the use of a specialized real-data transform, such as the fast Hartley transform (FHT), for example, able to exploit such properties. To give an indication of the size of FFT required for a realistic scenario, consider the case where 6.4K useable carrier signal channels are available, as obtained with a 16K-channel (i.e. as required for the carrier signals) system after filtering to a pass-band edge of 0.8 times the maximum frequency, this leading to an FFT/ IFFT requirement for the combined 3rd order and 5th order IMP case that could be satisfied with a transform of length 5 x 6.4K = 32K. From Equation 27, the total memory requirement of the proposed system, based upon the adoption of such a parameter, equates to approximately 6.2 Mbytes.

Apparatus

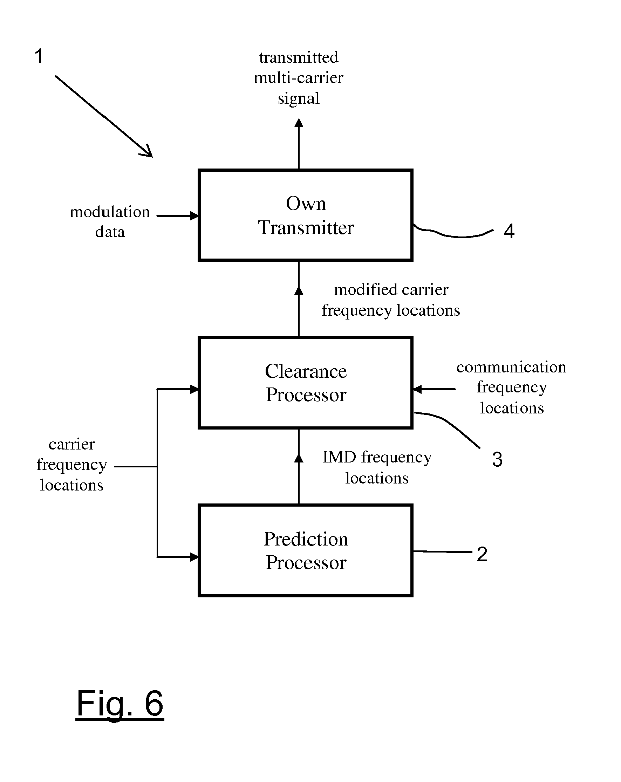

Fig. 6 shows a schematic block diagram of a communications apparatus 1 in accordance with the present invention. A prediction processor 2 performs the task of predicting the locations and strengths of the distortion, whilst the clearance processor 3 performs the task of clearing the channels of interest of distortion for the purposes of reliable communications. Also shown is a transmitter 4 for transmitting the desired multi-carrier signal, subject to the modulation data as has been described above. Here, the PA causing the distortion is not shown.

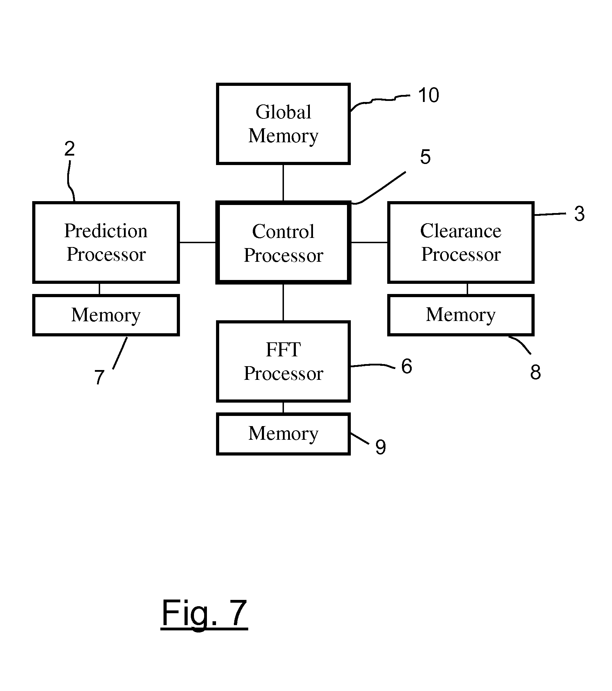

Fig. 7 schematically shows how the main components that make up the device interact with each other. As shown, the prediction processor 2, and the clearance processor 3 are controlled by a control processor 5, which also controls an FFT processor 6. Each of processors 2, 3 and 6 has a local memory associated with it (7, 8, 9), while a global memory 10 is associated with the control processor 5. The prediction processor 2 performs the task of predicting IMP locations and strengths, whilst the clearance processor 3 performs the task of clearing the channels of interest of IMD for the purpose of reliable communications. The FFT processor 6 performs the dual tasks of transforming the data-domain representation of polynomial coefficient sets to the Fourier domain as well as transforming the Fourier-domain representation of polynomial coefficient sets to the data domain. The prediction processor 2, clearance processor 3 and FFT processor 6 each have access to their own local memory in order to maximize the speed with which the associated computations are performed. The control processor 5 controls the flow of data between the three other processors and between itself and the outside world and ensures that the operation of the other three processors is appropriately synchronized so as to deliver the correct outputs, i.e. the modified carrier frequency locations, from the clearance processor 3 to the transmitter 4, as shown in Fig. 6, from which the modulated multi-carrier signal is subsequently transmitted.

It will be apparent to those skilled in the art that the above-described embodiments are exemplary only, and various modifications may be made within the scope of the claims.

**Claims**

1. A communications method comprising, as a first step, a method for predicting the locations and/or strengths of inter-modulation products in a modulated multi-carrier signal transmission, comprising the steps of:

   a) producing a polynomial arithmetic expression associated with the generation of $3^{rd}$ order and/or $5^{th}$ order inter-modulation products arising from the combining of all of the multi-carrier signal subsets of the transmission associated with those inter-modulation products, and

   b) embedding the polynomial arithmetic expression between a single FFT/IFFT pair, such that the locations and strengths of all $3^{rd}$ order and/or all $5^{th}$ order inter-modulation products are predicted;

   and, as a second step, a method for determining, for a modulated multi-carrier signal transmission comprising a plurality of non-overlapping frequency channels, the frequency channel location of one of those carrier signals that are responsible for the generation of inter-modulation distortion in the transmission, comprising the steps of:

   c) partitioning the plurality of carrier signal channels into a plurality of non-overlapping subsets,

   d) determining the reduction in the strength of inter-modulation products resulting from the removal of each subset from the transmission, and

   e) comparing the determined strengths,

   whereby the subset whose removal results in the largest determined reduction in strength of inter-modulation products in the channel of interest is determined to be primarily responsible for the generation of inter-modulation distortion in the signal;

   and whereby the locations and strengths of all $3^{rd}$ order and/or all $5^{th}$ order inter-modulation products predicted in step b) are used in step d);

   the method further comprising the step of removing or relocating the carrier signal at the location determined in step e) to reduce the residual level of inter-modulation distortion in the transmission frequency channel of interest.

2. A method according to claim 1, wherein the inter-modulation products comprise $3^{rd}$ order inter-modulation products, and the multi-carrier signal subsets associated with those inter-modulation products comprise 2-carrier and 3-carrier signal subsets.

3. A method according to either of claims 1 and 2, wherein the inter-modulation products comprise $5^{th}$ order inter-modulation products, and the multi-carrier signal subsets associated with those inter-modulation products comprise 2-carrier, 3-carrier, 4-carrier and 5-carrier signal subsets.

4. A method according to any preceding claim, wherein the transmission takes place over a range of non-overlapping frequency channels and comprises setting up a binary polynomial coefficient set in dependence of the presence of a carrier signal within a frequency channel, for each such frequency channel.

5. A method according to claim 4, wherein the coefficient set is transformed from the data domain to the Fourier domain.

6. The method according to claim 5, wherein the transformation is carried out using a FFT routine.

7. A method according to either of claims 5 and 6, wherein the transformed set is cyclically re-sampled to produce expressions for individual carrier signal subsets.

8. A method according to claim 7, wherein the expressions are combined to form a single expression.

9. A method according to claim 8, wherein the expressions are combined by applying an element-wise vector product to the expressions.

10. A method according to either of claims 8 and 9, wherein the single expression is transformed from the Fourier domain to the data domain to provide a coefficient set for the polynomial representation of the inter-modulation product distribution.

11. A method according to claim 10, wherein the transformation is carried out using an IFFT routine.

12. A method according to either of claims 6 and 11, wherein the execution of each of the FFT or IFFT routines comprise the use of a real-data transform.

13. A method according to any preceding claim, wherein steps c) and d) are repeated for the subset whose removal results in the largest determined reduction in strength of inter-modulation products, to increase the accuracy of location.

14. A method according to any preceding claim, wherein step d) comprises determining the reductions in strengths of all $3^{rd}$ order and/or all $5^{th}$ order inter-modulation products in said transmission.

15. Apparatus for performing a method according to any preceding claim.

carrier region

IMP region

# Fig. 1

carrier signal
channel locations

Setting up of Indicator
Polynomial

Set up binary polynomial
coefficient set of '0s' and '1s'

Forward FFT

Transform indicator polynomial
coefficient set to Fourier domain

Cyclic Re-Samplings

Produce cyclically re-sampled
versions of spectrum for those
combinations of valid sets of
channel weights catering for
IMD types of interest

Element-Wise
Vector Products
+
Combining of Vector
Products

Combine expressions to obtain
single expression catering for
IMD types of interest

Inverse FFT

Transform to data domain to obtain
coefficient set for polynomial
representation of IMD distribution
for IMD types of interest

IMP channel locations &
strengths

Fig. 2

19

carrier signal
channel locations

Setting up of Indicator
Polynomial

Forward FFT

$3^{rd}$-Order
IMP Path

$5^{th}$-Order
IMP Path

Cyclic Re-Samplings

Cyclic Re-Samplings

Element-Wise
Vector Products
+
Combining of Vector
Products

Element-Wise
Vector Products
+
Combining of Vector
Products

Inverse FFT

Inverse FFT

$3^{rd}$-order IMP channel
locations & strengths

$5^{th}$-order IMP channel
locations & strengths

combined IMP channel
locations & strengths

# Fig. 3

EP 2 693 645 A2

carrier signal
channel locations

Partitioning of latest set of carrier
signal channels into 'R'
non-overlapping subsets

1

Modify indicator
polynomial

IMP channel
location to be
cleared

Calculate residual IMD
at channel of interest
using predictor

R

Modify indicator
polynomial

Calculate residual IMD
at channel of interest
using predictor

Select 'best' subset of
carrier signal channels
leading to smallest
residual IMD

Repeat loop 'E' times

Residual IMD > delta
&
Attempts not exhausted?

YES – repeat

Modify initial set of
carrier signal channel
locations

NO – stop

Fig. 4

21

carrier signal
channel locations

fine-grained
pipeline

Real-to-Complex FFT

fine-grained
pipeline/SIMD

Cyclic Re-Sampling

Repeat

Processing

Loop

fine-grained
pipeline/SIMD

Element-Wise
Vector Products
+
Combining of Vector
Products

E×R×no_of_attempts + 1

Times

fine-grained
pipeline

Complex-to-Real IFFT

cleared communications
channel

# Fig. 5

1

transmitted
multi-carrier
signal

↑

modulation
data → | Own
Transmitter | ⟿ 4

↑ modified carrier
frequency locations

| Clearance
Processor | ← communication
frequency
locations
⟿ 3

carrier
frequency
locations

↑ IMD frequency
locations

| Prediction
Processor | — 2

# Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S.G. AKL.** The Design and Analysis of Parallel Algorithms. Prentice-Hall, 1989
- **G. BARUFFA ; G. REALI.** A Fast Counting Method for Generic Order Inter-Modulation Products. *Proc. IEEE Global Telecomms. Conf. (GLOBECOM '02), Taipei, Taiwan,* November 2002, 2036-2040
- **N.M. BLACHMAN.** Detectors, Bandpass Non-Linearities and their Optimization: Inversion of the Chebyshev Transform. *IEEE Trans on information Theory,* 1971, vol. 17, 398-404
- **R.N. BRACEWELL.** The Hartley Transform. Oxford University Press, 1986
- **E. CHU ; A. GEORGE.** Inside the FFT Black Box. CRC Press, 2002
- **D.C. GREEN.** Radio Communication. Longman, 2000
- **D. HAREL.** Algorithmics: The Spirit of Computing. Addison-Wesley, 1997
- **KJ. JONES.** The Regularized Fast Hartley Transform. Springer, 2010
- **A.V. OPPENHEIM ; R.W. SCHAFER.** Discrete-Time Signal Processing. Prentice-Hall, 1989
- **T.S. RAPPAPORT.** Wireless Communications: Principles and Practice. Prentice-Hall PTR, 1999